# EUROPÄISCHE PATENTANMELDUNG

(11) **EP 4 435 997 A1**
(43) Veröffentlichungstag der Anmeldung: **25.09.2024**
(21) Anmeldenummer: 23163807.3
(22) Anmeldetag: 23.03.2023
(51) Int. Cl.: H02J 7/00, B25F 5/00

(54) **VERFAHREN UND SYSTEM ZUM BETREIBEN EINES ELEKTRISCH ANGETRIEBENEN BEARBEITUNGSGERÄTS MIT MINDESTENS EINEM AKKUPACK, ELEKTRISCH ANGETRIEBENES BEARBEITUNGSGERÄT UND/ODER AKKUPACK**

(71) Anmelder: Andreas Stihl AG & Co. KG, 71336 Waiblingen (DE)
(72) Erfinder: SAUERTEIG, Daniel, 71394 Kernen im Remstal (DE); SCHMIDT, Tobias, 71149 Bondorf (DE)
(74) Vertreter: Patentanwälte Ruff, Wilhelm, Beier, Dauster & Partner mbB

(57) **Zusammenfassung**

Die Erfindung bezieht sich auf ein Verfahren zum Betreiben eines elektrisch angetriebenen Bearbeitungsgeräts (1) mit mindestens einem Akkupack (2), der zur Versorgung des Bearbeitungsgeräts (1) mit elektrischer Antriebsleistung (AL) vorgesehen ist, wobei das Verfahren die Schritte aufweist:
a) Erfassen einer Temperatur (T) des Akkupacks (2), insbesondere einer Akkumulatorzelle (2Z) des Akkupacks (2), mittels eines Temperatursensors (11) des Akkupacks (2),
b) Bestimmen einer Widerstandsgröße (RG) des Akkupacks (2) in Abhängigkeit von der erfassten Temperatur (T) mittels des Akkupacks (2), und
c) Betreiben des Bearbeitungsgeräts (1) in Abhängigkeit von der bestimmten Widerstandsgröße (RG).

## Beschreibung

### ANWENDUNGSGEBIET UND STAND DER TECHNIK

Die Erfindung bezieht sich auf ein Verfahren und ein System, insbesondere jeweils, zum Betreiben eines elektrisch angetriebenen Bearbeitungsgeräts mit mindestens einem Akkupack und ein elektrisch angetriebenes Bearbeitungsgerät und/oder einen Akkupack für ein solches System.

### AUFGABE UND LÖSUNG

Der Erfindung liegt als Aufgabe die Bereitstellung eines Verfahrens und eines Systems zum Betreiben eines elektrisch angetriebenen Bearbeitungsgeräts mit mindestens einem Akkupack zugrunde, das verbesserte Eigenschaften aufweist. Des Weiteren liegt der Erfindung als Aufgabe die Bereitstellung eines elektrisch angetriebenen Bearbeitungsgeräts und/oder eines Akkupacks für ein solches System zugrunde.

Die Erfindung löst diese Aufgabe durch die Bereitstellung eines Verfahrens, eines Systems und eines elektrisch angetriebenen Bearbeitungsgeräts und/oder eines Akkupacks beschrieben in den unabhängigen Ansprüchen. Vorteilhafte Weiterbildungen und/oder Ausgestaltungen der Erfindung sind in den abhängigen Ansprüchen beschrieben.

Das erfindungsgemäße Verfahren ist zum Betreiben eines elektrisch angetriebenen Bearbeitungsgeräts mit mindestens einem Akkupack (Englisch: battery pack), insbesondere mehreren Akkupacks. Der Akkupack ist zur Versorgung des Bearbeitungsgeräts mit elektrischer Antriebsleistung vorgesehen. Das Verfahren weist die Schritte auf: a) Erfassen einer Temperatur des Akkupacks, insbesondere einer Akkumulatorzelle des Akkupacks, mittels eines Temperatursensors des Akkupacks, b) Bestimmen einer Widerstandsgröße des Akkupacks, insbesondere mindestens der Akkumulatorzelle, in Abhängigkeit von der erfassten Temperatur mittels des Akkupacks, c) Betreiben des Bearbeitungsgeräts in Abhängigkeit von der bestimmten Widerstandsgröße, insbesondere mittels des Bearbeitungsgeräts.

Dies, insbesondere das Erfassen und das Bestimmen mittels des Akkupacks, ermöglicht eine Einfachheit des Bearbeitungsgeräts und/oder eine Spezifizität der Widerstandsgröße.

Zusätzlich oder alternativ, insbesondere somit, ermöglicht dies eine Optimalität des Betreibens des Bearbeitungsgeräts mit dem Akkupack, insbesondere bei einer tiefen bzw. kalten Temperatur.

Insbesondere können/kann das Verfahren, das Betreiben, die Versorgung, das Erfassen und/oder das Bestimmen automatisch und/oder computerimplementiert sein.

Das Bearbeitungsgerät und/oder der Akkupack können/kann mobil bzw. portabel sein. Insbesondere kann mobil eine Masse von maximal 50 kg (Kilogramm), insbesondere maximal 20 kg, insbesondere maximal 10 kg, insbesondere maximal 5 kg, und/oder minimal 0,2 kg, insbesondere minimal 0,5 kg, insbesondere minimal 1 kg, insbesondere minimal 2 kg, bedeuten.

Das Bearbeitungsgerät kann ein Bearbeitungswerkzeug und/oder einen Elektroantriebsmotor, insbesondere zum Antrieb des Bearbeitungswerkzeugs, aufweisen. Insbesondere kann die Antriebsleistung für den Elektroantriebsmotor sein.

Der Akkupack kann eine Mehrzahl von den Akkumulatorzellen aufweisen. Insbesondere können die Akkumulatorzellen jeweils einzelne wieder aufladbare Speicherelemente für elektrische Energie auf elektrochemischer Basis sein. Zusätzlich oder alternativ können die Akkumulatorzellen Lithium-Ionen-Akkumulatorzellen sein. Weiter zusätzlich oder alternativ können die Akkumulatorzellen gleich sein, insbesondere typ- und/oder baugleich. Weiter zusätzlich oder alternativ kann eine jeweilige Zell-Spannung, insbesondere Zell-Nennspannung, einer jeweiligen der Akkumulatorzellen minimal 2 V (Volt) und/oder maximal 4,2 V, insbesondere 3,6 V, sein. Weiter zusätzlich oder alternativ können die Akkumulatorzellen Rundzellen, prismatische Zellen oder Pouchzellen sein.

Das Bearbeitungsgerät und der Akkupack können miteinander zur Versorgung lösbar elektrisch, und insbesondere mechanisch, verbunden sein. Insbesondere können das Bearbeitungsgerät und der Akkupack lösbare elektrische Leistungskontakte zur Versorgung aufweisen. Zusätzlich oder alternativ kann die Verbindung mit Berührung sein bzw. die Leistungskontakte können zur Berührung voneinander vorgesehen sein. Weiter zusätzlich oder alternativ können die Leistungskontakte Steckverbinder aufweisen, insbesondere sein. Weiter zusätzlich oder alternativ kann der Begriffsbestandteil "Terminal" für den Begriffsbestandteil "Kontakt" synonym verwendet werden. Weiter zusätzlich oder alternativ kann der Begriff "gekoppelt" für den Begriff "verbunden" synonym verwendet werden. Weiter zusätzlich oder alternativ kann lösbar werkzeugfrei, zerstörungsfrei und/oder durch einen Benutzer lösbar sein. Weiter zusätzlich oder alternativ können das Bearbeitungsgerät und der Akkupack zur Entnahme und/oder zum Austausch des Akkupacks vorgesehen sein, insbesondere durch den Benutzer. Insbesondere kann das Bearbeitungsgerät einen Akkuschacht aufweisen, wobei der Akkuschacht zur Aufnahme des Akkupacks vorgesehen sein kann.

Der Begriff "ausgebildet", "konfiguriert" oder "eingerichtet" kann für den Begriff "vorgesehen" synonym verwendet werden.

Der Begriff "umfasst" oder "hat" kann für den Begriff "aufweist" synonym verwendet werden.

Der Begriff "Messen" kann für den Begriff "Erfassen" synonym verwendet werden.

Der Temperatursensor kann elektrisch sein.

Der Temperatursensor kann ein elektrisches Signal als Maß für die Temperatur liefern bzw. die Temperatur kann mittels des Signals erfasst werden.

Die Temperatur kann auf mindestens 1 °C (Grad Celsius) genau erfasst werden.

Die Temperatur und/oder die Widerstandsgröße können/kann einen Wert aufweisen.

Die Widerstandsgröße kann ein elektrischer Widerstand sein. Zusätzlich oder alternativ kann oder braucht nicht die Widerstandsgröße die Temperatur sein. Weiter zusätzlich oder alternativ kann die Widerstandsgröße eine Gleichspannungs- und/oder Innenwiderstandsgröße aufweisen, insbesondere sein. Weiter zusätzlich oder alternativ kann das Betreiben in Abhängigkeit von einer weiteren Widerstandsgröße, wie z.B. einer Kontakt- und/oder Leitungswiderstandsgröße, erfolgen.

Die Formulierung "basierend auf" kann für die Formulierung "in Abhängigkeit von" synonym verwendet werden.

Der Begriff "Kontrollieren" kann für den Begriff "Betreiben" synonym verwendet werden.

Der Begriff "Berechnen" kann für den Begriff "Bestimmen" synonym verwendet werden.

Das Bestimmen kann mittels einer, insbesondere elektrischen, Bestimmungseinrichtung des Akkupacks erfolgen.

Das Betreiben kann mittels einer, insbesondere elektrischen, Betriebseinrichtung, insbesondere des Bearbeitungsgeräts, erfolgen.

Der Schritt b) kann zeitlich nach dem Schritt a) erfolgen. Zusätzlich oder alternativ kann der Schritt c) zeitlich nach dem Schritt b) erfolgen.

Die Formulierung "ausgeführt werden" kann für den Begriff "erfolgen" synonym verwendet werden.

Der Schritt a) und/oder der Schritt b) können/kann oder brauchen/braucht nicht mittels des Bearbeitungsgeräts erfolgen.

Das Bearbeitungsgerät kann oder braucht nicht einen Temperatursensor, insbesondere zum Erfassen der Temperatur des Akkupacks, aufweisen.

Insbesondere kann der Schritt c) aufweisen: Betreiben des Bearbeitungsgeräts in Abhängigkeit von einer Ladezustandsgröße, insbesondere einem Ladezustand, und/oder einer Alterungszustandsgröße, insbesondere einem Alterungszustand (Englisch: State of Health), des Akkupacks.

In einer Weiterbildung der Erfindung weist der Schritt b) auf: Bestimmen der Widerstandsgröße in Abhängigkeit von der Ladezustandsgröße, insbesondere dem Ladezustand, und/oder der Alterungszustandsgröße, insbesondere dem Alterungszustand, des Akkupacks, insbesondere mittels des Akkupacks. Insbesondere weist das Verfahren den Schritt auf, insbesondere zeitlich vor dem Schritt b): Erfassen einer Spannung des Akkupacks für die Ladezustandsgröße, insbesondere mittels des Akkupacks. Zusätzlich oder alternativ weist das Verfahren den Schritt auf, insbesondere zeitlich vor dem Schritt b): Erfassen eines Aufladestroms des Akkupacks für eine Aufladegröße, insbesondere einer Ladung, und insbesondere einer, insbesondere der, Spannung des Akkupacks, für die Alterungszustandsgröße, insbesondere mittels des Akkupacks und/oder eines, insbesondere elektrischen, Ladegeräts. Dies ermöglicht eine besonders gute Spezifizität der Widerstandsgröße und somit eine besonders gute Optimalität des Betreibens. Insbesondere können/kann die Ladezustandsgröße, die Alterungszustandsgröße, die Spannung, der Aufladestrom und/oder die Aufladegröße einen Wert aufweisen. Zusätzlich oder alternativ können/kann die Ladezustandsgröße und/oder die Alterungszustandsgröße auf mindestens 1 % (Prozent) genau sein. Weiter zusätzlich oder alternativ kann das Erfassen automatisch sein. Weiter zusätzlich oder alternativ kann das Erfassen der Spannung mittels eines, insbesondere elektrischen, Spannungssensors erfolgen. Weiter zusätzlich oder alternativ kann das Erfassen des Aufladestroms mittels eines, insbesondere elektrischen, Stromsensors erfolgen. Weiter zusätzlich oder alternativ können der Akkupack und das Ladegerät miteinander zur Versorgung des Akkupacks mit elektrischer Aufladeleistung lösbar elektrisch, und insbesondere mechanisch, verbindbar, insbesondere verbunden, sein. Insbesondere können zu einem Zeitpunkt entweder der Akkupack und das Ladegerät oder der Akkupack und das Bearbeitungsgerät miteinander zur Versorgung verbunden sein. Weiter zusätzlich oder alternativ kann die Alterungszustandsgröße in dem Akkupack, insbesondere einer Speichereinrichtung des Akkupacks, gespeichert sein. Weiter zusätzlich oder alternativ kann die Alterungszustandsgröße über eine Aufladezykluszahl und/oder eine Aufladezykluszeitdauer ermittelt werden. Im Übrigen wird auf die Fachliteratur verwiesen.

In einer Weiterbildung der Erfindung weist das Verfahren den Schritt auf: Erfassen einer, insbesondere der, Spannung, insbesondere mittels des Akkupacks und/oder des Bearbeitungsgeräts. Der Schritt c) weist auf: Betreiben des Bearbeitungsgeräts in Abhängigkeit von der erfassten Spannung, insbesondere derart, dass die Spannung oberhalb einer Abschaltungsspannungsgrenze zur Schutzabschaltung des Akkupacks vor einer Unterspannung bleibt. Dies ermöglicht eine besonders gute Optimalität des Betreibens, insbesondere eine maximale Ausnutzung eines Spannungsfensters des Akkupacks, und/oder, dass die Abschaltungsspannungsgrenze nicht erreicht wird. Insbesondere kann das Erfassen automatisch sein. Zusätzlich oder alternativ kann das Erfassen der Spannung mittels eines, insbesondere elektrischen, Spannungssensors erfolgen. Weiter zusätzlich oder alternativ kann die Spannung auf mindestens 1 V (Volt) genau erfasst werden. Weiter zusätzlich oder alternativ können/kann die Spannung und/oder die Abschaltungsspannungsgrenze einen Wert aufweisen. Weiter zusätzlich oder alternativ kann der Begriff "Entladeschlussspannung" für den Begriff "Abschaltungsspannungsgrenze" synonym verwendet werden. Weiter zusätzlich oder alternativ kann der Begriffsbestandteil "Schwelle" für den Begriffsbestandteil "Grenze" synonym verwendet werden. Weiter zusätzlich oder alternativ kann eine Abschaltungsspannungsgrenzgröße, insbesondere die Abschaltungsspannungsgrenze, in dem Bearbeitungsgerät, insbesondere einer Speichereinrichtung des Bearbeitungsgeräts, hinterlegt sein, insbesondere gespeichert.

In einer Weiterbildung der Erfindung weist das Verfahren den Schritt auf: Bestimmen einer Maximalantriebsleistungs- und/oder Maximalantriebsstromgröße, insbesondere einer Maximalantriebsleistung und/oder eines Maximalantriebsstroms, in Abhängigkeit von der Widerstandsgröße, der erfassten Spannung und der Abschaltungsspannungsgrenzgröße, insbesondere der Abschaltungsspannungsgrenze, insbesondere mittels des Bearbeitungsgeräts und/oder des Akkupacks. Der Schritt c) weist auf: Betreiben des Bearbeitungsgeräts in Abhängigkeit von der bestimmten Maximalantriebsleistungs- und/oder Maximalantriebsstromgröße, insbesondere bis zu einer Erreichung der Maximalantriebsleistungs- und/oder Maximalantriebsstromgröße. Dies ermöglicht, dass die Spannung oberhalb der Abschaltungsspannungsgrenze bleibt bzw. immer auf einen Wert knapp oberhalb der Abschaltungsspannungsgrenze einbricht. Zusätzlich oder alternativ ermöglicht dies, insbesondere die Erreichung der Maximalantriebsleistungs- und/oder Maximalantriebsstromgröße, eine besonders gute Optimalität des Betreibens, insbesondere eine maximale Ausnutzung eines Leistungsfensters des Akkupacks, und/oder eine maximale bzw. schnelle Eigenerwärmung des Akkupacks bei der tiefen Temperatur bzw. eine schnelle Erhöhung der Temperatur. Somit ermöglicht dies eine schnelle Reduktion bzw. Senkung bzw. Erniedrigung der Widerstandsgröße. Somit ermöglicht dies eine schnelle Erhöhung bzw. Steigerung der Maximalantriebsleistungs- und/oder Maximalantriebsstromgröße und/oder einen niedrigen bzw. minimalen Energieverbrauch dafür. Insbesondere kann das Bestimmen automatisch und/oder computerimplementiert sein. Zusätzlich oder alternativ kann das Bestimmen mittels einer, insbesondere elektrischen, Bestimmungseinrichtung erfolgen. Weiter zusätzlich oder alternativ kann der Begriffsbestandteil "Entlade" für den Begriffsbestandteil "Antriebs" synonym verwendet werden. Weiter zusätzlich oder alternativ kann die Maximalantriebsleistungs- und/oder Maximalantriebsstromgröße einen Wert aufweisen. Weiter zusätzlich oder alternativ können/kann das Bestimmen der Maximalantriebsleistungs- und/oder Maximalantriebsstromgröße und/oder das Betreiben erfolgen derart, dass eine maximale Maximalantriebsleistungs- und/oder Maximalantriebsstromgröße bzw. Spitzen-Maximalantriebsleistungs- und/oder Maximalantriebsstromgröße, insbesondere zum Schutz des Akkupacks und/oder des Bearbeitungsgeräts vor einer Überbelastung, nicht überschritten wird. Weiter zusätzlich oder alternativ kann das Betreiben erfolgen derart, dass die Maximalantriebsleistungs- und/oder Maximalantriebsstromgröße nicht überschritten wird.

In einer Weiterbildung, insbesondere einer Ausgestaltung, der Erfindung weist das Bearbeitungsgerät einen, insbesondere den, Elektroantriebsmotor auf. Das Betreiben weist auf: Betreiben des Elektroantriebsmotors zu einer Erhöhung einer elektrischen Antriebsleistung des Elektroantriebsmotors, insbesondere ausgehend von Null und/oder zu einer Erreichung einer Soll-Drehzahl und/oder eines Soll-Drehmoments des Elektroantriebsmotors. Insbesondere wird mindestens, insbesondere nur, bei der Antriebsleistung Null die Widerstandsgröße bestimmt und/oder mindestens, insbesondere nur, bei der Antriebsleistung Null wird die Spannung erfasst. Dies ermöglicht einen schnellen Anlauf, insbesondere ein schnelles Starten, des Bearbeitungsgeräts mit dem Akkupack, insbesondere bei der tiefen Temperatur, und/oder wobei typischerweise ein Antriebsleistungsbedarf bzw. eine Belastung bzw. ein Spannungseinbruch am höchsten bzw. größten ist. Zusätzlich oder alternativ ermöglicht dies das Bestimmen der Widerstandsgröße und/oder der Maximalantriebsleistungs- und/oder Maximalantriebsstromgröße zeitlich vor dem Betreiben, insbesondere dem Starten. Weiter zusätzlich oder alternativ ermöglicht dies, insbesondere das Bestimmen und/oder das Erfassen bei der Antriebsleistung Null, eine starke Aussagekraft der Widerstandsgröße und/oder der Spannung. Insbesondere kann die Widerstandsgröße bestimmt werden und/oder die Spannung kann erfasst werden zu jedem Zeitpunkt. Aber nur die bei der Antriebsleistung Null bestimmte Widerstandsgröße und/oder die bei der Antriebsleistung Null erfasste Spannung können/kann verwendet werden und/oder das Bearbeitungsgerät kann immer erst dann darauf reagieren, wenn bzw. falls die Antriebsleistung Null war. Zusätzlich oder alternativ kann das Betreiben zu einer Erhöhung einer Drehzahl des Elektroantriebsmotors erfolgen, insbesondere aus dem Stillstand. Insbesondere können/kann in dem Stillstand die Widerstandsgröße bestimmt werden und/oder die Spannung erfasst werden. Im Übrigen wird auf die Fachliteratur verwiesen.

Insbesondere kann dies einen schnelleren Anlauf, insbesondere ein schnelleres Starten ermöglichen, als ein Anlaufen über eine reine Regelung der Spannung, wozu ein Strom (z.B. über einen langsamen Drehzahlanstieg des Bearbeitungsgeräts) über eine Rampe erhöht werden muss, wobei ein Einbruch der Spannung des Akkupacks gemessen werden muss. Bei typischen Bearbeitungsgeräten, welche in kürzester Zeit beschleunigen sollen, kann oder braucht dies nicht möglich sein. Z.B. Laststromanstieg in wenigen Mikrosekunden, wozu eine Spannungsmessung im 10 bis 100 Nanosekunden Bereich notwendig für eine Regelung wäre, was nicht mit handelsüblichen Mikrocontrollern darstellbar sein kann oder braucht.

In anderen Worten: Erfindungsgemäß kann oder braucht nicht rein die Spannung geregelt werden derart, dass die Spannung oberhalb der Abschaltungsspannungsgrenze bleibt.

Zusätzlich oder alternativ kann dies einen schnelleren Anlauf, insbesondere ein schnelleres Starten ermöglichen, als ein Ermitteln der Widerstandsgröße mittels eines Erzeugens und eines Auswertens eines Stromtestimpulses zeitlich vor dem eigentlichen Starten.

In anderen Worten: Erfindungsgemäß kann oder braucht nicht ein Strom vor dem Starten erfasst werden bzw. das vorhergehend Genannte ist in dem Stillstand möglich.

Insbesondere kann das Verfahren den Schritt aufweisen, insbesondere zeitlich nach dem Schritt b) und/oder zeitlich vor dem Schritt c): Kommunizieren der erfassten Spannung und/oder der bestimmten Maximalantriebsleistungs- und/oder Maximalantriebsstromgröße von dem Akkupack an das Bearbeitungsgerät.

In einer Weiterbildung der Erfindung weist das Verfahren den Schritt auf, insbesondere zeitlich nach dem Schritt b) und/oder zeitlich vor dem Schritt c): Kommunizieren der bestimmten Widerstandsgröße von dem Akkupack an das Bearbeitungsgerät. Der Schritt c) weist auf: Betreiben des Bearbeitungsgeräts in Abhängigkeit von der kommunizierten Widerstandsgröße. Insbesondere kann das Kommunizieren automatisch sein. Zusätzlich oder alternativ kann das Kommunizieren mittels einer, insbesondere elektrischen, Kommunikationseinrichtung, insbesondere des Akkupacks und/oder des Bearbeitungsgeräts, erfolgen. Weiter zusätzlich oder alternativ können das Bearbeitungsgerät und der Akkupack lösbare elektrische Kommunikationskontakte zu dem Kommunizieren aufweisen. Insbesondere können die Kommunikationskontakte zur Berührung voneinander vorgesehen sein. Zusätzlich oder alternativ können die Kommunikationskontakte Steckverbinder aufweisen, insbesondere sein. Weiter zusätzlich oder alternativ kann der Schritt aufweisen: Kommunizieren der Abschaltungsspannungsgrenzgröße, insbesondere der Abschaltungsspannungsgrenze, und/oder der erfassten Temperatur von dem Akkupack an das Bearbeitungsgerät. Der Schritt c) kann aufweisen: Betreiben des Bearbeitungsgeräts in Abhängigkeit von der kommunizierten Abschaltungsspannungsgrenzgröße.

In einer Weiterbildung, insbesondere einer Ausgestaltung, der Erfindung erfolgen/erfolgt der Schritt a) und/oder der Schritt b), und insbesondere das Erfassen der Spannung und/oder das Bestimmen der Maximalantriebsleistungs- und/oder Maximalantriebsstromgröße und/oder das Kommunizieren der Widerstandsgröße, mindestens, insbesondere nur und/oder unmittelbar bzw. direkt, zeitlich vor jedem Betreiben, insbesondere jeder Erhöhung der Antriebsleistung ausgehend von Null, insbesondere erfolgen/erfolgt erneut, insbesondere bis die maximale Maximalantriebsleistungs- und/oder Maximalantriebsstromgröße erreicht ist. Dies ermöglicht eine Aktualität der Temperatur, der Widerstandsgröße, der Spannung und/oder der Maximalantriebsleistungs- und/oder Maximalantriebsstromgröße. Insbesondere kann der Begriff "wiederholt" für den Begriff "erneut" synonym verwendet werden.

In einer Weiterbildung, insbesondere einer Ausgestaltung, der Erfindung weist das Verfahren den Schritt auf: falls die erfasste Temperatur unterhalb einer Tieftemperaturgrenze ist und/oder die bestimmte Widerstandsgröße oberhalb einer Widerstandsgrößegrenze ist und/oder die bestimmte Maximalantriebsleistungs- und/oder Maximalantriebsstromgröße unterhalb einer Maximalantriebsleistungs- und/oder Maximalantriebsstromgrößegrenze ist, Ausgeben, insbesondere Anzeigen, einer benutzerwahrnehmbaren Information darüber, insbesondere mittels des Bearbeitungsgeräts. Dies ermöglicht für den Benutzer ein Feedback, insbesondere des Warmfahrmodus. Insbesondere können/kann die Tieftemperaturgrenze, die Widerstandsgrößegrenze und/oder die Maximalantriebsleistungs- und/oder Maximalantriebsstromgrößegrenze in dem Akkupack und/oder dem Bearbeitungsgerät, insbesondere einer Speichereinrichtung des Akkupacks und/oder des Bearbeitungsgeräts, hinterlegt sein, insbesondere gespeichert. Zusätzlich oder alternativ kann das Ausgeben automatisch sein. Weiter zusätzlich oder alternativ kann das Ausgeben mittels einer, insbesondere elektrischen Ausgabeeinrichtung, insbesondere einer Anzeige, erfolgen. Insbesondere kann die Anzeige mindestens eine LED aufweisen, insbesondere sein. Weiter zusätzlich oder alternativ kann die Information einen Inhalt aufweisen.

In einer Weiterbildung, insbesondere einer Ausgestaltung, der Erfindung weist das Bearbeitungsgerät ein benutzerbetätigbares, insbesondere benutzerverstellbares, Bedienelement auf, insbesondere für die Soll-Drehzahl. Der Schritt c) bzw. das Betreiben erfolgt ausgelöst durch eine, insbesondere in Abhängigkeit von einer, Betätigung, insbesondere Verstellung, des Bedienelements. Im Übrigen wird auf die Fachliteratur verwiesen.

In einer Weiterbildung der Erfindung weist der Schritt b) auf: Bestimmen der Widerstandsgröße mittels eines Modells, insbesondere eines Kennfelds, des Akkupacks. Dies ermöglicht eine Genauigkeit der Widerstandsgröße. Insbesondere kann das Modell mathematisch sein. Zusätzlich oder alternativ kann das Modell eine Tabelle und/oder eine Funktion aufweisen, insbesondere sein. Weiter zusätzlich oder alternativ kann die Temperatur als eine Eingangsgröße des Modells bezeichnet werden. Weiter zusätzlich oder alternativ kann die Widerstandsgröße als eine Ausgangsgröße des Modells bezeichnet werden. Weiter zusätzlich oder alternativ kann das Modell in dem Akkupack, insbesondere einer Speichereinrichtung des Akkupacks, hinterlegt sein, insbesondere gespeichert. Weiter zusätzlich oder alternativ kann der Begriff "Kennlinienfeld" für den Begriff "Kennfeld" synonym verwendet werden.

In einer Weiterbildung der Erfindung ist das Bearbeitungsgerät aus einer Menge von mit dem Akkupack lösbar elektrisch verbindbaren verschiedenen Bearbeitungsgeräten gewählt.

Zusätzlich oder alternativ ist der Akkupack aus einer Menge von mit dem Bearbeitungsgerät lösbar elektrisch verbindbaren verschiedenen Akkupacks gewählt. Insbesondere können zu einem Zeitpunkt entweder der Akkupack und das Bearbeitungsgerät oder der Akkupack und ein anderes Bearbeitungsgerät miteinander zur Versorgung verbunden sein. Zusätzlich oder alternativ können die Akkupacks verschieden sein in einer, insbesondere der, jeweiligen Widerstandsgröße und/oder einer, insbesondere der, jeweiligen Abhängigkeit, insbesondere aufgrund verschiedenen Akkumulatorzellen, verschiedener Zellverschaltung und/oder verschiedenen Systemdesigns.

In einer Weiterbildung der Erfindung ist das Bearbeitungsgerät boden- und/oder handgeführt, insbesondere handgetragen, und/oder ein Garten-, Forst-, Bau- und/oder Bodenbearbeitungsgerät. Insbesondere ist das Bearbeitungsgerät eine Säge, oder ein Hoch-Entaster, oder eine Heckenschere, oder ein Heckenschneider, oder ein Gehölzschneider, oder eine Astschere, oder ein Trennschleifer, oder ein Blasgerät, oder ein Laubbläser, oder ein Sauggerät, oder ein Laubsauger, oder ein Reinigungsgerät, oder ein Hochdruckreiniger, oder ein Kehrgerät, oder eine Kehrwalze, oder eine Kehrbürste, oder ein Rasenmäher, oder eine Grasschere, oder ein Freischneider, oder ein Vertikutierer. Dies, insbesondere das Verfahren, ist für ein solches Bearbeitungsgerät besonders gut.

Das erfindungsgemäße System ist zum Betreiben des elektrisch angetriebenen Bearbeitungsgeräts mit mindestens dem Akkupack. Der Akkupack ist zur Versorgung des Bearbeitungsgeräts mit elektrischer Antriebsleistung vorgesehen. Das System weist den Temperatursensor des Akkupacks, die Bestimmungseinrichtung des Akkupacks und die Betriebseinrichtung auf. Der Temperatursensor ist zu dem Erfassen der Temperatur des Akkupacks vorgesehen. Die Bestimmungseinrichtung ist zu dem Bestimmen der Widerstandsgröße des Akkupacks in Abhängigkeit von der erfassten Temperatur vorgesehen. Die Betriebseinrichtung ist zu dem Betreiben des Bearbeitungsgeräts in Abhängigkeit von der bestimmten Widerstandsgröße vorgesehen. Das System kann den/die gleichen Vorteil/e wie für das Verfahren vorhergehend genannt ermöglichen. Insbesondere kann das System zum, insbesondere automatischen, Ausführen des Verfahrens wie vorhergehend genannt vorgesehen sein. Zusätzlich oder alternativ kann das System elektrisch sein. Weiter zusätzlich oder alternativ können/kann das System, die Bestimmungseinrichtung und/oder die Betriebseinrichtung eine Recheneinrichtung und/oder einen Prozessor und/oder einen Mikrocontroller und/oder eine Speichereinrichtung und/oder einen Computer aufweisen, insbesondere sein. Weiter zusätzlich oder alternativ kann das System die Kommunikationseinrichtung aufweisen, wobei die Kommunikationseinrichtung zu dem Kommunizieren der bestimmten Widerstandsgröße von dem Akkupack an das Bearbeitungsgerät vorgesehen sein kann.

In einer Weiterbildung der Erfindung weist das System das Bearbeitungsgerät, insbesondere wobei das Bearbeitungsgerät die Betriebseinrichtung aufweist, und/oder den Akkupack auf. Insbesondere können/kann das Bearbeitungsgerät und/oder der Akkupack wie für das Verfahren vorhergehend genannt vorgesehen sein. Insbesondere kann das System das Ladegerät aufweisen.

Das erfindungsgemäße elektrisch angetriebene Bearbeitungsgerät und/oder der erfindungsgemäße Akkupack sind/ist für das System wie vorhergehend genannt.

### KURZBESCHREIBUNG DER ZEICHNUNGEN

Weitere Vorteile und Aspekte der Erfindung ergeben sich aus den Ansprüchen und aus der Beschreibung von Ausführungsbeispielen der Erfindung, die nachfolgenden anhand der Figuren erläutert sind. Dabei zeigen:
- Fig. 1: schematisch ein erfindungsgemäßes System aufweisend ein erfindungsgemäßes elektrisch angetriebenes Bearbeitungsgerät und einen erfindungsgemäßen Akkupack und ein erfindungsgemäßes Verfahren zum Betreiben des Bearbeitungsgeräts mit dem Akkupack,
- Fig. 2: schematisch ein Modell zum Bestimmen einer Widerstandsgröße des Akkupacks,
- Fig. 3: schematisch eine Maximalantriebsleistungs- und/oder Maximalantriebsstromgröße zum Betreiben des Bearbeitungsgeräts über einer Zeit, eine Spannung des Akkupacks über der Zeit, und eine Temperatur des Akkupacks über der Zeit,
- Fig. 4: schematisch eine Drehzahl eines Elektroantriebsmotors des Bearbeitungsgeräts über der Zeit, und
- Fig. 5: schematisch ein Ersatzschaltbild des Akkupacks.

### DETAILLIERTE BESCHREIBUNG DER AUSFÜHRUNGSBEISPIELE

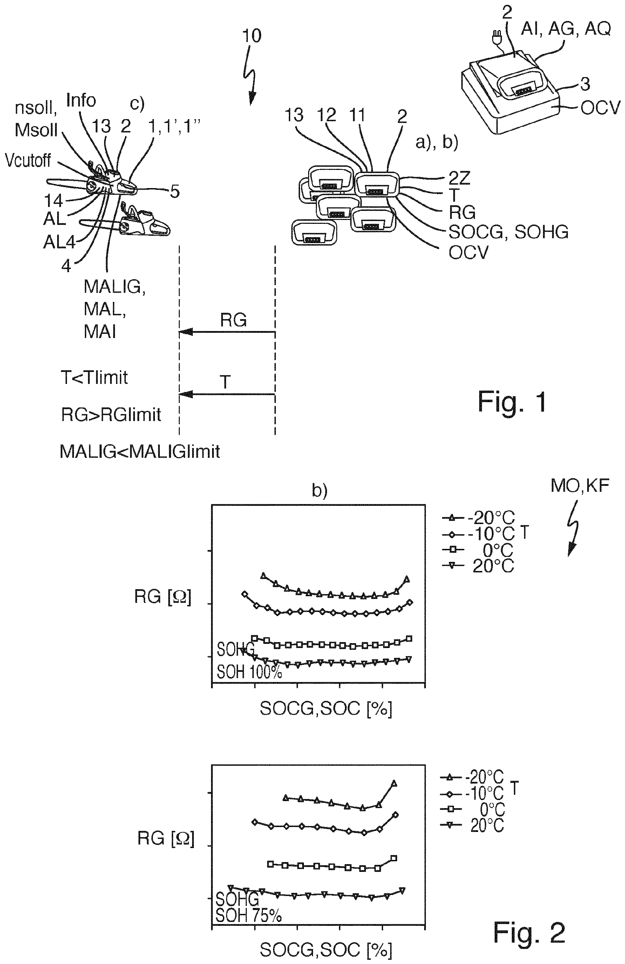

Fig. 1 zeigt ein erfindungsgemäßes System 10 und ein erfindungsgemäßes Verfahren zum Betreiben eines erfindungsgemäßen elektrisch angetriebenen Bearbeitungsgeräts 1 mit mindestens einem erfindungsgemäßen Akkupack 2. Der Akkupack 2 ist zur Versorgung des Bearbeitungsgeräts 1 mit elektrischer Antriebsleistung AL vorgesehen, insbesondere versorgt.

Das System 10 weist einen Temperatursensor 11 des Akkupacks 2, eine Bestimmungseinrichtung 12 des Akkupacks 2 und eine Betriebseinrichtung 14 auf. Der Temperatursensor 11 ist zum Erfassen einer Temperatur T des Akkupacks 2 vorgesehen, insbesondere erfasst. Die Bestimmungseinrichtung 12 ist zum Bestimmen einer Widerstandsgröße RG des Akkupacks 2 in Abhängigkeit von der erfassten Temperatur T vorgesehen, insbesondere bestimmt, wie in Fig. 2 gezeigt. Die Betriebseinrichtung 14 ist zum Betreiben des Bearbeitungsgeräts 1 in Abhängigkeit von der bestimmten Widerstandsgröße RG vorgesehen, insbesondere betreibt.

Im Detail weist das System 10 das Bearbeitungsgerät 1, insbesondere wobei das Bearbeitungsgerät 1 die Betriebseinrichtung 14 aufweist, und/oder den Akkupack 2 auf.

Das Verfahren weist die Schritte auf: a) Erfassen der Temperatur T des Akkupacks 2, insbesondere einer Akkumulatorzelle 2Z des Akkupacks 2, mittels des Temperatursensors 11 des Akkupacks 2. b) Bestimmen der Widerstandsgröße RG des Akkupacks 2 in Abhängigkeit von der erfassten Temperatur T mittels des Akkupacks 2. c) Betreiben des Bearbeitungsgeräts 1 in Abhängigkeit von der bestimmten Widerstandsgröße RG.

Im Detail weist der Schritt b) auf: Bestimmen der Widerstandsgröße RG in Abhängigkeit von einer Ladezustandsgröße SOCG, insbesondere einem Ladezustand SOC, und/oder einer Alterungszustandsgröße SOHG, insbesondere einem Alterungszustand SOH, des Akkupacks 2, wie in Fig. 2 gezeigt. Insbesondere weist das Verfahren den Schritt auf, insbesondere zeitlich vor dem Schritt b): Erfassen einer Spannung OCV des Akkupacks 2 für die Ladezustandsgröße SOCG, insbesondere mittels des Akkupacks 2. Zusätzlich oder alternativ weist das Verfahren den Schritt auf, insbesondere zeitlich vor dem Schritt b): Erfassen eines Aufladestroms Al des Akkupacks 2 für eine Aufladegröße AG, insbesondere einer Ladung AQ, und insbesondere einer Spannung OCV des Akkupacks 2, für die Alterungszustandsgröße SOHG, insbesondere mittels des Akkupacks 2 und/oder eines Ladegeräts 3.

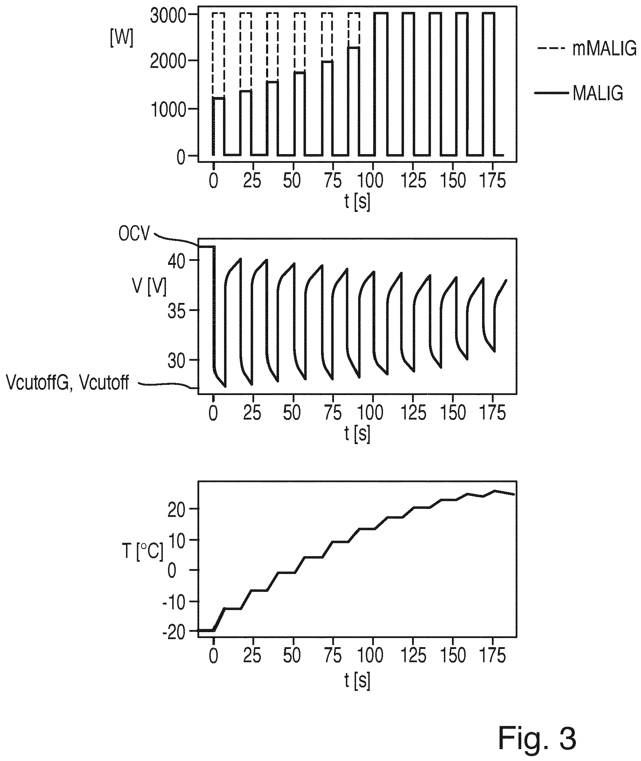

Des Weiteren weist das Verfahren den Schritt auf: Erfassen einer, insbesondere der, Spannung OCV, insbesondere mittels des Akkupacks 2 und/oder des Bearbeitungsgeräts 1. Der Schritt c) weist auf: Betreiben des Bearbeitungsgeräts 1 in Abhängigkeit von der erfassten Spannung OCV, insbesondere derart, dass die Spannung V oberhalb einer Abschaltungsspannungsgrenze Vcutoff zur Schutzabschaltung des Akkupacks 2 vor einer Unterspannung bleibt, wie in Fig. 3, mittig gezeigt.

Im Detail weist das Verfahren den Schritt auf: Bestimmen einer Maximalantriebsleistungs-und/oder Maximalantriebsstromgröße MALIG, insbesondere einer Maximalantriebsleistung MAL und/oder eines Maximalantriebsstroms MAI, in Abhängigkeit von der Widerstandsgröße RG, der erfassten Spannung OCV und einer Abschaltungsspannungsgrenzgröße VcutoffG, insbesondere der Abschaltungsspannungsgrenze Vcutoff, insbesondere mittels des Bearbeitungsgeräts 1. Der Schritt c) weist auf: Betreiben des Bearbeitungsgeräts 1 in Abhängigkeit von der bestimmten Maximalantriebsleistungs- und/oder Maximalantriebsstromgröße MALIG, insbesondere bis zu einer Erreichung der Maximalantriebsleistungs- und/oder Maximalantriebsstromgröße MALIG, wie in Fig. 3, oben und mittig gezeigt.

In anderen Worten: MAI = (OCV - Vcutoff - Vmargin) / (RG + R1) bzw. MAL = MAI x Vcutoff mit Vmargin für eine Spannungstoleranz und mit R1 für einen Widerstand des Bearbeitungsgeräts 1.

Insbesondere erfolgen/erfolgt das Bestimmen der Maximalantriebsleistungs- und/oder Maximalantriebsstromgröße MALIG und/oder das Betreiben derart, dass eine maximale Maximalantriebsleistungs- und/oder Maximalantriebsstromgröße mMALIG nicht überschritten wird, wie im Fig 3, oben gezeigt.

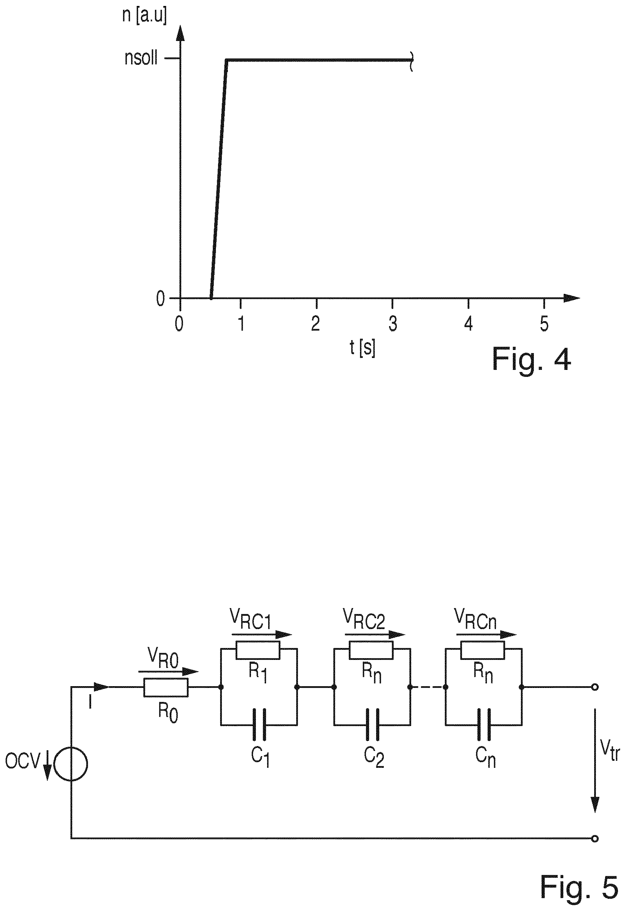

Außerdem weist das Bearbeitungsgerät 1 einen Elektroantriebsmotor 4 auf. Das Betreiben weist auf: Betreiben des Elektroantriebsmotors 4 zu einer Erhöhung einer elektrischen Antriebsleistung AL4, insbesondere einer Drehzahl n, des Elektroantriebsmotors 4, insbesondere ausgehend von Null und/oder zu einer Erreichung einer Soll-Drehzahl nsoll und/oder eines Soll-Drehmoments Msoll des Elektroantriebsmotors 4, wie in Fig. 4 bei 0 s bis 1 s gezeigt. Insbesondere wird mindestens bei der Antriebsleistung AL4 Null die Widerstandsgröße RG bestimmt und/oder mindestens bei der Antriebsleistung Null wird die Spannung OCV erfasst.

Weiter weist das Verfahren den Schritt auf, insbesondere zeitlich nach dem Schritt b) und/oder zeitlich vor dem Schritt c): Kommunizieren der bestimmten Widerstandsgröße RG von dem Akkupack 2 an das Bearbeitungsgerät 1, insbesondere mittels einer Kommunikationseinrichtung 13, insbesondere des Akkupacks 2 und/oder des Bearbeitungsgeräts 1, wie in Fig. 1 gezeigt. Der Schritt c) weist auf: Betreiben des Bearbeitungsgeräts 1 in Abhängigkeit von der kommunizierten Widerstandsgröße RG.

Zudem erfolgen/erfolgt der Schritt a) und/oder der Schritt b), und insbesondere das Erfassen der Spannung OCV und/oder das Bestimmen der Maximalantriebsleistungs- und/oder Maximalantriebsstromgröße MALIG und/oder das Kommunizieren der Widerstandsgröße RG, mindestens zeitlich vor jedem Betreiben, insbesondere jeder Erhöhung der Antriebsleistung AL4 ausgehend von Null, insbesondere erfolgen/erfolgt erneut, insbesondere bis die maximale Maximalantriebsleistungs- und/oder Maximalantriebsstromgröße mMALIG erreicht ist, wie in Fig. 3, gezeigt.

Dies ermöglicht eine schnelle Eigenerwärmung des Akkupacks 2 bei der tiefen Temperatur T bzw. eine schnelle Erhöhung der Temperatur T. Somit ermöglicht dies eine schnelle Senkung der Widerstandsgröße RG. Somit ermöglicht dies eine schnelle Steigerung der Maximalantriebsleistungs- und/oder Maximalantriebsstromgröße MALIG und/oder einen minimalen Energieverbrauch dafür.

In anderen Worten: Eine aktuell mögliche Maximalantriebsleistungs- und/oder Maximalantriebsstromgröße MALIG wird bestimmt. Bei einem weiteren Anlauf des Bearbeitungsgeräts 1 wird die dann aktuell mögliche Maximalantriebsleistungs- und/oder Maximalantriebsstromgröße MALIG bestimmt, die aufgrund der Erwärmung des Akkupacks 2 bzw. der Erhöhung der Temperatur T und der dadurch gesunkenen Widerstandsgröße RG gegenüber der zeitlich davor bestimmten gestiegen ist.

Des Weiteren weist das Verfahren den Schritt auf: falls die erfasste Temperatur T unterhalb einer Tieftemperaturgrenze Tlimit ist und/oder die bestimmte Widerstandsgröße RG oberhalb einer Widerstandsgrößegrenze RGlimit ist und/oder die bestimmte Maximalantriebsleistungs-und/oder Maximalantriebsstromgröße MALIG unterhalb einer Maximalantriebsleistungs-und/oder Maximalantriebsstromgrößegrenze MALIGIimit ist, Ausgeben, insbesondere Anzeigen, einer benutzerwahrnehmbaren Information Info darüber, insbesondere mittels des Bearbeitungsgeräts 1, wie in Fig. 1 gezeigt.

Außerdem weist das Bearbeitungsgerät 1 ein benutzerbetätigbares, insbesondere benutzerverstellbares, Bedienelement 5 auf, insbesondere für die Soll-Drehzahl nsoll. Der Schritt c) erfolgt ausgelöst durch eine, insbesondere in Abhängigkeit von einer, Betätigung, insbesondere Verstellung, des Bedienelements 5.

Weiter weist der Schritt b) auf: Bestimmen der Widerstandsgröße RG mittels eines Modells MO, insbesondere eines Kennfelds KF, des Akkupacks 2, wie in Fig. 2 gezeigt.

Im Detail zeigt Fig. 5 schematisch ein Ersatzschaltbild des Akkupacks 2. Das Widerstandsverhalten des Akkupacks 2 kann als serielle Verschaltung eines Widerstands mit weiteren RC-Gliedern verstanden bzw. modelliert werden. Bei sprunghafter Belastung mit einem Strompuls fällt unmittelbar eine Spannung am R0 ab. Der Spannungsabfall an den RC-Gliedern stellt sich zeitabhängig entsprechend derer Zeitkonstanten ein. Das Modell MO, insbesondere das Kennfeld KF, insbesondere eine Bedatung davon, zum Bestimmen der Widerstandsgröße RG ist so ausgelegt, dass die Zeitkonstanten für die typischen Anwendungsfälle des Akkupacks 2 berücksichtigt sind.

Zudem ist das Bearbeitungsgerät 1 aus einer Menge von mit dem Akkupack 2 lösbar elektrisch verbindbaren verschiedenen Bearbeitungsgeräten 1 gewählt. Zusätzlich oder alternativ ist der Akkupack 2 aus einer Menge von mit dem Bearbeitungsgerät 1 lösbar elektrisch verbindbaren verschiedenen Akkupacks 2 gewählt.

Des Weiteren ist das Bearbeitungsgerät 1 boden- und/oder handgeführt, insbesondere handgetragen, und/oder ein Garten-, Forst-, Bau- und/oder Bodenbearbeitungsgerät 1'. Insbesondere ist das Bearbeitungsgerät 1 eine Säge 1", oder ein Hoch-Entaster, oder eine Heckenschere, oder ein Heckenschneider, oder ein Gehölzschneider, oder eine Astschere, oder ein Trennschleifer, oder ein Blasgerät, oder ein Laubbläser, oder ein Sauggerät, oder ein Laubsauger, oder ein Reinigungsgerät, oder ein Hochdruckreiniger, oder ein Kehrgerät, oder eine Kehrwalze, oder eine Kehrbürste, oder ein Rasenmäher, oder eine Grasschere, oder ein Freischneider, oder ein Vertikutierer.

Im Übrigen ist eine, insbesondere elektrische, Nennspannung des Akkupacks 2 und/oder des Bearbeitungsgeräts 1 36 V. In alternativen Ausführungsbeispielen kann die Nennspannung weniger oder mehr als 36 V sein, insbesondere 18 V oder 72 V.

Zusätzlich oder alternativ ist die Antriebsleistung AL minimal 10 Watt (W), insbesondere minimal 100 W, insbesondere minimal 1 kW (Kilowatt), insbesondere minimal 2 kW, und/oder maximal 10 kW, insbesondere maximal 5 kW, insbesondere 3kW.

Weiter zusätzlich oder alternativ ist ein maximaler, insbesondere elektrischer, Energieinhalt, insbesondere Nennenergieinhalt, des Akkupacks 2 minimal 50 Wh (Wattstunden), insbesondere minimal 100 Wh, insbesondere minimal 200 Wh, und/oder maximal 4000 Wh, insbesondere maximal 2000 Wh, insbesondere maximal 1000 Wh, insbesondere maximal 500 Wh, insbesondere 337 Wh.

Wie die gezeigten und vorhergehend erläuterten Ausführungsbeispiele deutlich machen, stellt die Erfindung das vorteilhafte Verfahren und das vorteilhafte System zum Betreiben des elektrisch angetriebenen Bearbeitungsgeräts mit mindestens dem Akkupack bereit, das verbesserte Eigenschaften aufweist. Des Weiteren stellt die Erfindung das vorteilhafte elektrisch angetriebene Bearbeitungsgerät und/oder den vorteilhaften Akkupack für das System bereit.

## Patentansprüche

1. Verfahren zum Betreiben eines elektrisch angetriebenen Bearbeitungsgeräts (1) mit mindestens einem Akkupack (2), der zur Versorgung des Bearbeitungsgeräts (1) mit elektrischer Antriebsleistung (AL) vorgesehen ist, wobei das Verfahren die Schritte aufweist:
a) Erfassen einer Temperatur (T) des Akkupacks (2), insbesondere einer Akkumulatorzelle (2Z) des Akkupacks (2), mittels eines Temperatursensors (11) des Akkupacks (2),
b) Bestimmen einer Widerstandsgröße (RG) des Akkupacks (2) in Abhängigkeit von der erfassten Temperatur (T) mittels des Akkupacks (2), und
c) Betreiben des Bearbeitungsgeräts (1) in Abhängigkeit von der bestimmten Widerstandsgröße (RG).

2. Verfahren nach Anspruch 1,
- wobei der Schritt b) aufweist: Bestimmen der Widerstandsgröße (RG) in Abhängigkeit von einer Ladezustandsgröße (SOCG), insbesondere einem Ladezustand (SOC), und/oder einer Alterungszustandsgröße (SOHG), insbesondere einem Alterungszustand (SOH), des Akkupacks (2),
- insbesondere wobei das Verfahren den Schritt aufweist, insbesondere zeitlich vor dem Schritt b): Erfassen einer Spannung (OCV) des Akkupacks (2) für die Ladezustandsgröße (SOCG), insbesondere mittels des Akkupacks (2), und/oder
- insbesondere wobei das Verfahren den Schritt aufweist, insbesondere zeitlich vor dem Schritt b): Erfassen eines Aufladestroms (AI) des Akkupacks (2) für eine Aufladegröße (AG), insbesondere einer Ladung (AQ), und insbesondere einer Spannung (OCV) des Akkupacks (2), für die Alterungszustandsgröße (SOHG), insbesondere mittels des Akkupacks (2) und/oder eines Ladegeräts (3).

3. Verfahren nach Anspruch 1 oder 2,
- wobei das Verfahren den Schritt aufweist: Erfassen einer, insbesondere der, Spannung (OCV), insbesondere mittels des Akkupacks (2) und/oder des Bearbeitungsgeräts (1), und
- wobei der Schritt c) aufweist: Betreiben des Bearbeitungsgeräts (1) in Abhängigkeit von der erfassten Spannung (OCV), insbesondere derart, dass die Spannung (V) oberhalb einer Abschaltungsspannungsgrenze (Vcutoff) zur Schutzabschaltung des Akkupacks (2) vor einer Unterspannung bleibt.

4. Verfahren nach Anspruch 3,
- wobei das Verfahren den Schritt aufweist: Bestimmen einer Maximalantriebsleistungs-und/oder Maximalantriebsstromgröße (MALIG), insbesondere einer Maximalantriebsleistung (MAL) und/oder eines Maximalantriebsstroms (MAI), in Abhängigkeit von der Widerstandsgröße (RG), der erfassten Spannung (OCV) und einer Abschaltungsspannungsgrenzgröße (VcutoffG), insbesondere der Abschaltungsspannungsgrenze (Vcutoff), insbesondere mittels des Bearbeitungsgeräts (1), und
- wobei der Schritt c) aufweist: Betreiben des Bearbeitungsgeräts (1) in Abhängigkeit von der bestimmten Maximalantriebsleistungs- und/oder Maximalantriebsstromgröße (MALIG), insbesondere bis zu einer Erreichung der Maximalantriebsleistungs- und/oder Maximalantriebsstromgröße (MALIG).

5. Verfahren nach einem der Ansprüche 1 bis 4, insbesondere Anspruch 3 oder 4,
- wobei das Bearbeitungsgerät (1) einen Elektroantriebsmotor (4) aufweist, und
- wobei das Betreiben aufweist: Betreiben des Elektroantriebsmotors (4) zu einer Erhöhung einer elektrischen Antriebsleistung (AL4) des Elektroantriebsmotors (4), insbesondere ausgehend von Null und/oder zu einer Erreichung einer Soll-Drehzahl (nsoll) und/oder eines Soll-Drehmoments (Msoll) des Elektroantriebsmotors (4),
- insbesondere wobei mindestens bei der Antriebsleistung (AL4) Null die Widerstandsgröße (RG) bestimmt wird und/oder die Spannung (OCV) erfasst wird.

6. Verfahren nach einem der Ansprüche 1 bis 5,
- wobei das Verfahren den Schritt aufweist, insbesondere zeitlich nach dem Schritt b) und/oder zeitlich vor dem Schritt c): Kommunizieren der bestimmten Widerstandsgröße (RG) von dem Akkupack (2) an das Bearbeitungsgerät (1), und
- wobei der Schritt c) aufweist: Betreiben des Bearbeitungsgeräts (1) in Abhängigkeit von der kommunizierten Widerstandsgröße (RG).

7. Verfahren nach einem der Ansprüche 1 bis 6, insbesondere Anspruch 3 oder 4 oder 6,
- wobei der Schritt a) und/oder der Schritt b), und insbesondere das Erfassen der Spannung (OCV) und/oder das Bestimmen der Maximalantriebsleistungs- und/oder Maximalantriebsstromgröße (MALIG) und/oder das Kommunizieren der Widerstandsgröße (RG), mindestens zeitlich vor jedem Betreiben, insbesondere jeder Erhöhung der Antriebsleistung (AL4) ausgehend von Null, erfolgen/erfolgt, insbesondere erneut erfolgen/erfolgt.

8. Verfahren nach einem der Ansprüche 1 bis 7, insbesondere Anspruch 4 oder einem von Anspruch 4 abhängigen Anspruch,
- wobei das Verfahren den Schritt aufweist: falls die erfasste Temperatur (T) unterhalb einer Tieftemperaturgrenze (Tlimit) ist und/oder die bestimmte Widerstandsgröße (RG) oberhalb einer Widerstandsgrößegrenze (RGlimit) ist und/oder die bestimmte Maximalantriebsleistungs- und/oder Maximalantriebsstromgröße (MALIG) unterhalb einer Maximalantriebsleistungs- und/oder Maximalantriebsstromgrößegrenze (MALIGIimit) ist, Ausgeben, insbesondere Anzeigen, einer benutzerwahrnehmbaren Information (Info) darüber, insbesondere mittels des Bearbeitungsgeräts (1).

9. Verfahren nach einem der Ansprüche 1 bis 8, insbesondere Anspruch 5 oder einem von Anspruch 5 abhängigen Anspruch,
- wobei das Bearbeitungsgerät (1) ein benutzerbetätigbares, insbesondere benutzerverstellbares, Bedienelement (5) aufweist, insbesondere für die Soll-Drehzahl (nsoll), und
- wobei der Schritt c) ausgelöst durch eine, insbesondere in Abhängigkeit von einer, Betätigung, insbesondere Verstellung, des Bedienelements (5) erfolgt.

10. Verfahren nach einem der Ansprüche 1 bis 9,
- wobei der Schritt b) aufweist: Bestimmen der Widerstandsgröße (RG) mittels eines Modells (MO), insbesondere eines Kennfelds (KF), des Akkupacks (2).

11. Verfahren nach einem der Ansprüche 1 bis 10,
- wobei das Bearbeitungsgerät (1) aus einer Menge von mit dem Akkupack (2) lösbar elektrisch verbindbaren verschiedenen Bearbeitungsgeräten (1) gewählt ist, und/oder
- wobei der Akkupack (2) aus einer Menge von mit dem Bearbeitungsgerät (1) lösbar elektrisch verbindbaren verschiedenen Akkupacks (2) gewählt ist.

12. Verfahren nach einem der Ansprüche 1 bis 11,
- wobei das Bearbeitungsgerät (1) boden- und/oder handgeführt, insbesondere handgetragen, und/oder ein Garten-, Forst-, Bau- und/oder Bodenbearbeitungsgerät (1') ist,
- insbesondere wobei das Bearbeitungsgerät (1) eine Säge (1"), oder ein Hoch-Entaster, oder eine Heckenschere, oder ein Heckenschneider, oder ein Gehölzschneider, oder eine Astschere, oder ein Trennschleifer, oder ein Blasgerät, oder ein Laubbläser, oder ein Sauggerät, oder ein Laubsauger, oder ein Reinigungsgerät, oder ein Hochdruckreiniger, oder ein Kehrgerät, oder eine Kehrwalze, oder eine Kehrbürste, oder ein Rasenmäher, oder eine Grasschere, oder ein Freischneider, oder ein Vertikutierer ist.

13. System (10) zum Betreiben eines elektrisch angetriebenen Bearbeitungsgeräts (1) mit mindestens einem Akkupack (2), der zur Versorgung des Bearbeitungsgeräts (1) mit elektrischer Antriebsleistung (AL) vorgesehen ist, insbesondere zum Ausführen eines Verfahrens nach einem der Ansprüche 1 bis 12, wobei das System (10) aufweist:
- einen Temperatursensor (11) des Akkupacks (2), der zum Erfassen einer Temperatur (T) des Akkupacks (2) vorgesehen ist,
- eine Bestimmungseinrichtung (12) des Akkupacks (2), die zum Bestimmen einer Widerstandsgröße (RG) des Akkupacks (2) in Abhängigkeit von der erfassten Temperatur (T) vorgesehen ist, und
- eine Betriebseinrichtung (14), die zum Betreiben des Bearbeitungsgeräts (1) in Abhängigkeit von der bestimmten Widerstandsgröße (RG) vorgesehen ist.

14. System (10) nach Anspruch 13, wobei das System (10) aufweist:
- das Bearbeitungsgerät (1), insbesondere wobei das Bearbeitungsgerät (1) die Betriebseinrichtung (14) aufweist, und/oder den Akkupack (2).

15. Elektrisch angetriebenes Bearbeitungsgerät (1) und/oder Akkupack (2) für ein System (10) nach Anspruch 13 oder 14.
